# EUROPÄISCHE PATENTSCHRIFT

(11) **EP 2 625 754 B1**
(45) Veröffentlichungstag und Bekanntmachung des Hinweises auf die Patenterteilung: **08.08.2018**
(21) Anmeldenummer: 11764711.5
(22) Anmeldetag: 28.09.2011
(51) Int. Cl.: H01S 5/022, H01S 5/024

(54) **LASERMODUL MIT EINER LASERDIODENEINHEIT UND EINEM KÜHLER SOWIE HERSTELLUNGSVERFAHREN FÜR EIN SOLCHES LASERMODUL**
LASER MODULE HAVING A LASER DIODE UNIT AND HAVING A COOLING MEANS, AND ALSO PRODUCTION METHOD FOR A LASER MODULE OF THIS KIND
MODULE LASER COMPRENANT UN ENSEMBLE DIODE LASER ET UN REFROIDISSEUR AINSI QUE PROCÉDÉ DE FABRICATION D'UN TEL MODULE LASER

(30) Priorität: 06.10.2010 DE 102010042087
(43) Veröffentlichungstag der Anmeldung: 14.08.2013
(73) Patentinhaber: JENOPTIK Laser GmbH, 07745 Jena (DE)
(72) Erfinder: SCHRÖDER, Matthias, 07646 Stadtroda (DE)
(74) Vertreter: Waldauf, Alexander
(86) Internationale Anmeldenummer: PCT/EP2011/066807
(87) Internationale Veröffentlichungsnummer: WO 2012/045619

(56) Entgegenhaltungen:
- EP-A2- 1 519 458
- JP-A- 2003 163 045
- JP-A- 2004 111 507
- US-A- 5 404 368
- US-A1- 2005 238 074

## Beschreibung

Die vorliegende Erfindung betrifft ein Lasermodul mit einer Laserdiodeneinheit und einem Kühler sowie ein Herstellungsverfahren für ein solches Lasermodul.
Die Laserdiodeneinheit weist häufig eine Wärmesenke mit einer daran befestigten Laserdiode auf, wobei für die Wärmesenke Kupfer bzw. eine Kupferlegierung verwendet wird. Für den Kühler kann Aluminium bzw. eine Aluminiumlegierung verwendet werden, wobei die elektrische Kontaktierung der Laserdiode über Kühler und Wärmesenke durchgeführt wird. Dazu ist es vorteilhaft, die Wärmesenke mit dem Kühler mit einem niedrigen elektrischen Übergangswiderstand zu verbinden, was jedoch aufgrund der nicht vermeidbaren Oxidschicht auf dem aus Aluminium bzw. einer Aluminiumlegierung hergestellten Kühler schwierig ist. Um den gewünschten niedrigen elektrischen Übergangswiderstand zwischen Kupfer und Aluminium zu erreichen, ist es bekannt, eine stoffschlüssige Verbindung durch eine aufwendige Lötung mit einem Speziallot durchgeführt. Ferner kann ein elektrisch leitender Kleber verwendet werden, der jedoch wieder nachteilig zu einem höheren elektrischen Übergangswiderstand führt. Aus US 2005/0238074 A1 ist eine Laserdiodeneinheit bekannt, welche über eine Feder in einem Kühler elastisch fixiert wird. Aus US 5404368 A ist eine Vorrichtung mit einer Laserdiode bekannt, bei der ein Laserdiodenelement mit zwei Federkontakten angeschlossen wird. Nachteilig ist, dass die Kühlung des Laserchips unvorteilhafterweise nur einseitig erfolgt und dass zur elektrischen Kontaktierung Kontaktfedern erforderlich sind. Aus EP 1519458 ist ein Diodenlaser bekannt, bei dem ein Laserelement mittels einer radial belasteten vergoldeten Spiralfeder kontaktiert wird. Auch bei diesem Diodenlaser wird die Wärme vom Laserbarren unvorteilhafterweise nur einseitig abgeführt. Die Verwendung goldbeschichteter Kontaktflächen führt zu einem erwünschten niedrigen Kontaktwiderstand, hat aber den Nachteil hoher Herstellungskosten. Aus JP 2003-163045 A ist eine Kontaktfeder bekannt, mit der ein elektrisches Bauteil mit einer Leiterplatte verbunden werden kann. Ein solches Federelement kann unvorteilhafterweise keinen hohen Wärmestrom vom Bauteil ableiten

Die erfinderische Aufgabe wird gelöst durch eine Lasermodul und ein Verfahren zur Herstellung eines solchen gemäß den unabhängigen Ansprüchen. Vorteilhafte Ausbildungsformen sind in den abhängigen Ansprüchen definiert.

Da die Kontaktnase aufgrund des Positionierens z. B. in die erste Kontaktfläche des ersten Aufnahmebereichs gedrückt wird, wird eine unerwünschte Oxidschicht sicher aufgebrochen, so daß eine sehr gute elektrische Verbindung mit dem gewünschten niedrigen elektrischen Übergangswiderstand vorliegt.

Die Kontaktnase bei dem erfindungsgemäßen Lasermodul durchstößt oder bricht auf eine Passivierung der Kontaktfläche, in die sie beim Positionieren der Laserdiodeneinheit gedrückt wird, so daß die gewünschten Verringerung des elektrischen Übergangswiderstandes erreicht wird. Unter einer Passivierung wird hier eine elektrisch isolierende Schicht oder Beschichtung verstanden. Dabei kann es sich um eine spontane Passivierung handeln, wie z. B. die nicht vermeidbare Oxidschicht auf Aluminium oder einer Aluminiumlegierung. Es kann sich bei der Passivierung aber auch um eine extra aufgebrachte Schicht handeln, beispielsweise einer Schicht zum Korrosionsschutz. Zusätzlich kann die Kontaktnase selbst eine Passivierungsschicht aufweisen. In diesem Fall kann das Eindrücken der Kontaktnase in die erste oder zweite Kontaktfläche beim Positionieren der Laserdiodeneinheit dazu führen, daß die Passivierungsschicht auf der Kontaktnase selbst aufgebrochen oder abgestreift wird, so daß die gewünschte Verringerung des elektrischen Übergangswiderstandes erreicht wird.
Aufgrund des Vorsehens der Kontaktnase bei dem erfindungsgemäßen Lasermodul kann auf aufwendige Lötverfahren zur Herstellung einer stoffschlüssigen Verbindung mittels eines Speziallots verzichtet werden.
Der erste Aufnahmebereich kann z.B. als ebene Fläche, die die erste Kontaktfläche bildet, oder als Stufe mit einem Boden und einer Seitenwand ausgebildet sein, wobei der Boden oder die Seitenwand die erste Kontaktfläche bildet. Alternativ ist es möglich, daß der erste Aufnahmebereich als erste Aufnahmenut mit einem Boden und zwei Seitenwänden ausgebildet ist, wobei der Boden oder eine der beiden Seitenwände die erste Kontaktfläche bildet.

Bei dem erfindungsgemäßen Lasermodul weist die Laserdiodeneinheit eine Wärmesenke auf, wobei die Laserdiode an der Wärmesenke befestigt ist. Die Kontaktnase ist an der Wärmesenke selbst ausgebildet. Insbesondere kann die Kontaktnase an einem elastischen Schenkel der Wärmesenke ausgebildet sein. In diesem Fall wird die Elastizität des Schenkels dazu genutzt, eine vorbestimmte Rückstellkraft zu erzeugen, mit der gewährleistet ist, daß beim Positionieren der Laserdiodeneinheit im ersten Aufnahmebereich das Eindringen der Kontaktnase in die erste Kontaktfläche des ersten Aufnahmebereichs sicher erreicht wird.
Ferner kann die vorstehende Kontaktnase als Grat ausgebildet sein. In diesem Fall kann bei der Herstellung der Wärmesenke bzw. des Kühlers der übliche Entgratungsschritt ausgelassen werden, so daß zumindest ein Grat, der bei der mechanischen Bearbeitung der Wärmesenke bzw. des Kühlers (z.B. Stanzen zumindest eines Teiles der Wärmesenke bzw. des Kühlers) entstanden ist, bestehen bleibt und für die gewünschte Kontaktierung vorteilhaft eingesetzt werden kann.
Bei dem erfindungsgemäßen Lasermodul ist bevorzugt die Breite der Wärmesenke im Bereich der Kontaktnase größer als die minimale Breite der ersten Aufnahmenut. Dadurch wird sichergestellt, daß das Eindringen der Kontaktnase in die Seitenwand der ersten Aufnahmenut nach dem Positionieren bzw. Einsetzen der Laserdiodeneinheit in die erste Aufnahmenut vorliegt.
Die erste Aufnahmenut kann als V-Nut ausgebildet sein. In diesem Fall sind die Seitenwände nicht parallel zueinander, sondern relativ zum Boden so geneigt, daß mit zunehmendem Abstand vom Boden die Breite der ersten Aufnahmenut zunimmt. Natürlich sind auch andere Querschnittsformen der ersten Aufnahmenut möglich. So kann beispielsweise die erste Aufnahmenut als U-förmige Nut ausgebildet sein, bei der die Seitenwände zueinander parallel und senkrecht zum Boden verlaufen.

Die Wärmesenke weist ein Ober- und ein Unterteil auf, zwischen denen die Laserdiode angeordnet ist. Das Ober- und Unterteil dient neben der Wärmeabfuhr auch zur elektrischen Kontaktierung der Laserdiode. Daher ist bevorzugt zwischen Ober- und Unterteil eine isolierende Schicht so vorgesehen, daß kein direkter elektrischer Kontakt zwischen Ober- und Unterteil vorliegt. Jedoch liegt bevorzugt eine elektrische Kontaktierung einer ersten Seite der Laserdiode durch das Oberteil und einer zweiten Seite der Laserdiode durch das Unterteil vor.
Zumindest das Ober- oder Unterteil weist die vorstehende Kontaktnase auf, die für die elektrische Kontaktierung beim Positionieren der Laserdiodeneinheit im ersten Aufnahmebereich dient.

Bevorzugt weist das Ober- oder Unterteil zwei elastische Schenkel mit jeweils zumindest einer Kontaktnase auf, wobei die beiden Kontaktnasen voneinander wegweisen, so daß sie in beide Seitenwände der ersten Aufnahmenut eingedrückt sind.

Der Kühler weist ein erstes Kühlerteil mit dem ersten Aufnahmebereich sowie ein zweites Kühlerteil mit einem zweiten Aufnahmebereich auf, der eine dritte Kontaktfläche umfaßt. Ferner umfassen sowohl das Ober- und Unterteil der Wärmesenke zumindest eine Kontaktnase, so daß die Kontaktnase des Teils der Wärmesenke, der im ersten Aufnahmebereich positioniert ist, in die erste Kontaktfläche des ersten Aufnahmebereichs gedrückt ist, und die Kontaktnase des anderen Teils der Wärmesenke in die dritte Kontaktfläche des zweiten Aufnahmebereiches gedrückt ist. Die beiden Kühlerteile weisen bevorzugt keine direkte elektrische Verbindung miteinander auf, so daß eine ausgezeichnete elektrische Kontaktierung der Laserdiodeneinheit bzw. der Laserdiode erreicht werden kann. So liegt eine elektrische Kontaktierung der Laserdiode einerseits über das erste Kühlerteil und das darin eingesetzte Teil der Wärmesenke und andererseits über das zweite Kühlerteil und das darin eingesetzte Teil der Wärmesenke vor.
Der zweite Aufnahmebereich kann beispielsweise als ebene Fläche, die die dritte Kontaktfläche bildet, als Stufe mit einem Boden und einer Seitenwand, wobei der Boden oder die Seitenwand die zweite Kontaktfläche bildet, oder als zweite Aufnahmenut mit einem Boden und zwei Seitenwänden, wobei der Boden oder eine der beiden Seitenwände die zweite Kontaktfläche bildet, ausgebildet sein. Die zweite Aufnahmenut kann als V-Nut, als U-Nut oder als Nut mit einer anderen Querschnittsform ausgebildet sein.
Von dem Ober- und Unterteil kann zumindest eines einen Hauptabschnitt mit einer Vertiefung am vorderen Ende zur Aufnahme der Laserdiode sowie zumindest einen elastischen Schenkel mit einer Kontaktnase am hinteren Ende des Hauptabschnittes aufweisen. Ein solch ausgebildetes Ober- oder Unterteil läßt sich leicht herstellen.
Insbesondere kann das zumindest eine Ober- oder Unterteil am hinteren Ende des Hauptabschnittes zwei Schenkel mit jeweils zumindest einer Kontaktnase aufweisen. Damit wird an mehreren Stellen eine optimale Kontaktierung zwischen dem Ober- bzw. Unterteil und dem Kühler erreicht.
Die Breite des Oberteils kann im Bereich der Kontaktnase größer sein als die minimale Breite der Aufnahmenut, in die das Oberteil eingesetzt wird. Gleiches gilt für die Breite des Unterteils im Bezug auf die entsprechende Aufnahmenut.

Die erste und zweite Aufnahmenut in beiden Kühlerteilen können gleich oder verschieden ausgebildet sein. Insbesondere können sie als V-Nut oder als U-Nut ausgebildet sein.

Insbesondere können das Ober- und Unterteil gleich ausgebildet sein.

Ferner sind das Ober- und Unterteil der Wärmesenke so angeordnet, daß zwischen ihnen kein direkter elektrischer Kontakt vorliegt, jedoch die elektrische Kontaktierung der Laserdiode über das Ober- und Unterteil möglich ist.

Bei dem Lasermodul ist der Kühler bevorzugt aus Aluminium oder einer Aluminiumlegierung hergestellt. Erfindungsgemäß kann der Kühler auch aus einem anderen Materialien hergestellt sein, welches z. B. eine spontane Passivierung der Oberfläche aufweist, wie z. B. Zink, Titan, Nickel, Blei und/oder Silizium, oder welches z. B. aus Gründen des Korrosionsschutz passiviert werden kann, wie z. B. Kupfer, Eisen oder Kupferlegierungen. Ferner ist die Wärmesenke bevorzugt aus Kupfer oder einer Kupferlegierung hergestellt. Auch andere Materialien mit einer guten Wärmeleitfähigkeit sind möglich.

Ferner kann die äußere Oberfläche der Wärmesenke zumindest teilweise mit einer Nickel-Gold-Beschichtung versehen sein. Dies verbessert den Kontaktwiderstand. Insbesondere kann dann durch das mechanische Eindrücken der Kontaktnasen in die Seitenwand oder den Boden der entsprechenden Aufnahmenut auch eine Art Kaltverschweißung von Aluminium des Kühlers mit dem Nickel-Gold der Wärmesenke erreicht werden.

Bei dem erfindungsgemäßen Lasermodul kann die Kontaktnase an der ersten Kontaktfläche ausgebildet sein und kann die zweite Kontaktfläche eine Oberfläche der Wärmesenke oder der Laserdiode sein.

Bei dem erfindungsgemäßen Lasermodul kann die Laserdiode direkt auf dem Kühler montiert sein.

Die Kontaktnase kann insbesondere als Grat ausgebildet sein.

Ferner können die beschriebenen erfindungsgemäßen Ausgestaltungen des Lasermodules so miteinander kombiniert werden, daß eine vorstehende Kontaktnase an der Laserdiode oder an der Wärmesenke sowie eine vorstehende Kontaktnase an der ersten Kontaktfläche und/oder an der dritten Kontaktfläche vorgesehen ist. Damit wird eine weitere Verbesserung des Übergangswiderstands erreicht.

Natürlich kann das Lasermodul noch weitere dem Fachmann bekannte Elemente aufweisen, die zum Betrieb des Lasermoduls notwendig sind.

Die Aufgabe wird ferner gelöst durch ein Verfahren gemäß Anspruch 9 zum Herstellen eines Lasermoduls mit einem Kühler, der einen ersten Aufnahmebereich mit einer ersten Kontaktfläche aufweist, und einer Laserdiodeneinheit, die eine Laserdiode sowie eine zweite Kontaktfläche aufweist, wobei an einer der ersten oder zweiten Kontaktfläche eine Kontaktnase ausgebildet wird und die Laserdiodeneinheit im ersten Aufnahmebereich positioniert und dabei die Kontaktnase in die andere der ersten oder zweiten Kontaktfläche gedrückt wird, um den elektrischen Übergangswiderstand zwischen der Laserdiodeneinheit und dem Kühler zu verringern.

Durch dieses Vorgehen wird eine auf der Kontaktnase und/oder der ersten Kontaktfläche vorhandene Passivierung (wie z.B. eine unerwünschte Oxidschicht) sicher aufgebrochen, so daß eine sehr gute elektrische Verbindung mit dem gewünschten niedrigen elektrischen Übergangswiderstand vorliegt.
Weiterbildungen des erfindungsgemäßen Verfahrens sind in den abhängigen Verfahrensansprüchen angegeben. So kann z.B. die Kontaktnase während des Positionierens im ersten Aufnahmebereich an der ersten Kontaktfläche entlang kratzen und dabei eine auf der Kontaktnase und/oder der ersten Kontaktfläche vorhandene Passivierung aufbrechen. Somit kann die gewünschte gute elektrische Verbindung mit dem gewünschten niedrigen elektrischen Übergangswiderstand sicher hergestellt werden.
Ferner kann die Kontaktnase mit einer Fase ausgebildet werden. Dies ist z.B. von Vorteil, wenn der erste Aufnahmebereich als erste Aufnahmenut ausgebildet ist, insbesondere wenn die Seitenwände der Aufnahmenut sehr steil sind oder sich sogar senkrecht erstrecken.

Nachfolgend wird die Erfindung beispielsweise anhand der beigefügten Zeichnungen, die auch erfindungswesentliche Merkmale offenbaren, noch näher erläutert. Es zeigen:
- Fig. 1: eine schematische Ansicht einer ersten Ausführungsform des erfindungsgemäßen Lasermoduls;
- Fig. 2: eine Draufsicht auf das Unterteil 5 der Wärmesenke 6 von Fig. 1;
- Fig. 3: eine Draufsicht auf das Lasermodul von Fig. 1, wobei das zweite Kühlerteil 9 nicht dargestellt ist, und
- Fig. 4: eine Seitenansicht einer weiteren Ausführungsform des Unterteils 5 der Wärmesenke 6.

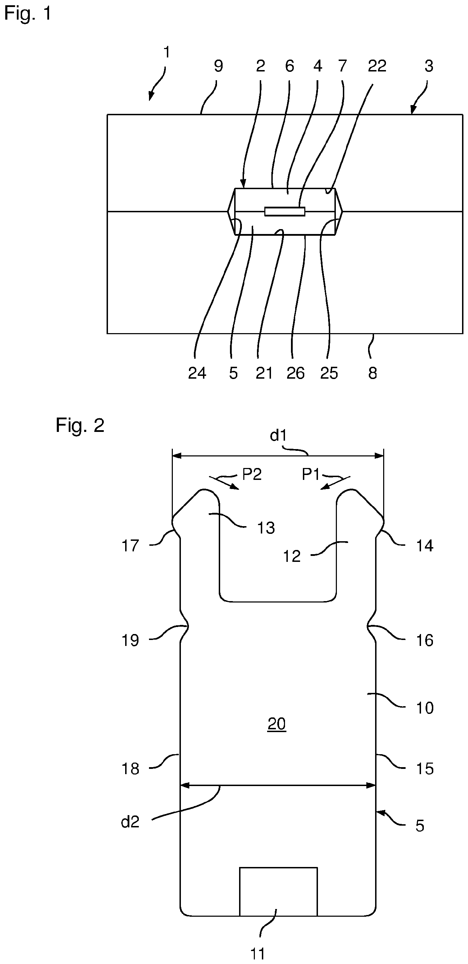

Bei der in Fig. 1 gezeigten Ausführungsform weist das erfindungsgemäße Lasermodul 1 eine Laserdiodeneinheit 2 sowie einen Kühler 3 auf, wobei die Laserdiodeneinheit 2 im Kühler 3 sitzt, der zur Wärmeabfuhr beim Betrieb des Lasermoduls 1 dient.

Die Laserdiodeneinheit 2 umfaßt eine ein Oberteil 4 und ein Unterteil 5 aufweisende Wärmesenke 6, wobei zwischen dem Oberteil 4 und dem Unterteil 5 eine Laserdiode 7 angeordnet ist. Zwischen den beiden Teilen 4,5 besteht kein direkter elektrischer Kontakt, da eine (nicht gezeigte) Isolierschicht zwischen ihnen vorgesehen ist. Die Isolierschicht ist so ausgebildet, daß die beiden Teile 4, 5 zum elektrischen Kontaktieren der Laserdiode 7 dienen. Das Unterteil 5 kann beispielsweise zur Kontaktierung der Epitaxieseite der Laserdiode 7 dienen, wohingegen das Oberteil 4 eine elektrische Kontaktierung der Substratseite der Laserdiode 7 bewirkt.

Das Ober- und Unterteil 4, 5 der Wärmesenke 6 ist hier aus Kupfer bzw. aus einer Kupferlegierung hergestellt, wobei bevorzugt alle Außenseiten der Wärmesenke 6 eine Nickel-Gold-Beschichtung aufweisen.

Das Oberteil 4 und das Unterteil 5 der Wärmesenke 6 sind gleich ausgebildet, so daß nachfolgend in Verbindung mit Figur 2 nur das Unterteil 5 im Detail beschrieben wird.

Wie aus der vergrößerten Draufsicht des Unterteils 5 in Fig. 2 ersichtlich ist, umfaßt das Unterteil 5 einen im wesentlichen rechteckförmigen Hauptabschnitt 10, der an seinem vorderen Ende eine Vertiefung 11 zur Aufnahme der Laserdiode 7 sowie zwei am hinteren Ende des Hauptabschnittes 10 anschließende Schenkel 12, 13 aufweist. Wie der Darstellung in Fig. 2 zu entnehmen ist, sind die beiden Schenkel 12, 13 spiegelsymmetrisch zueinander ausgebildet, wobei der Schenkel 12 eine Kontaktnase 14 aufweist, die relativ zur rechten Seite 15 des Hauptabschnittes 10 vorsteht. Ferner ist noch eine Einbuchtung 16 am Übergang zwischen dem Hauptabschnitt 10 und dem Schenkel 12 an der rechten Seite 15 ausgebildet, die dazu dient, eine Bewegung des Schenkels 12 in Richtung des Pfeils P1 zu erleichtern, wenn eine entsprechende Kraft auf die Kontaktnase 14 einwirkt, wie nachfolgend noch im Zusammenhang mit dem Einsetzen der Laserdiodeneinheit 2 in den Kühler 3 beschrieben wird.

Der Schenkel 13 weist in gleicher Weise wie der Schenkel 12 eine Kontaktnase 17 auf, die gegenüber der linken Seite 18 des Hauptabschnittes 10 vorsteht. Ferner ist beim Übergang vom Hauptabschnitt 10 zum linken Schenkel 13 eine Einbuchtung 19 vorgesehen, um eine Bewegung des linken Schenkels 13 in Richtung des Pfeils P2 zu erleichtern.

Aufgrund der beiden seitlich vorstehenden Kontaktnasen weist das Unterteil 5 im Bereich der Kontaktnasen 14, 17 eine Breite d1 auf, die größer ist als die Breite d2 des Hauptabschnitts 10.

Die Dicke des Unterteils 5 (Ausdehnung senkrecht zur Darstellung in Fig. 2) ist hier mit Ausnahme des Bereiches der Vertiefung 11 konstant. Die Höhe der Vertiefung 11 ist bevorzugt so gewählt, daß sie etwa der halben Dicke der Laserdiode 7 entspricht.

Die Laserdiodeneinheit 2 wird bevorzugt wie folgt hergestellt. Die in Fig. 2 gezeigte Oberseite 20 des Unterteils 5 wird mit Ausnahme des Bereiches der Vertiefung 11 mit einer elektrisch isolierenden Beschichtung versehen. Danach wird die Laserdiode 7 in die Vertiefung eingesetzt und mit dem Unterteil 5 verbunden. Dies kann beispielsweise durch Löten erfolgen.

Danach wird das Oberteil 4, das den gleiche Aufbau wie das Unterteil 5 aufweist, mit seiner Vertiefung auf das Unterteil 5 gesetzt, wobei wiederum bevorzugt eine Lotverbindung zwischen der Laserdiode 7 und dem Oberteil 4 erzeugt wird. Des weiteren kann das Oberteil 5 in den restlichen Bereichen mit dem Unterteil 5 bzw. der elektrisch isolierenden Beschichtung, die auf dem Unterteil 5 ausgebildet ist, fest verbunden werden (beispielsweise Verkleben). Natürlich kann die elektrisch isolierende Beschichtung des Unterteils weggelassen werden, wenn mittels des Verbindungsschrittes von Ober- und Unterteil 4, 5 die elektrisch isolierende Verbindung verwirklicht wird, die beim Vorsehen der elektrisch isolierenden Beschichtung vorliegt. Dazu kann z.B. ein elektrisch isolierender Kleber verwendet werden.

Wie insbesondere Fig. 1 zu entnehmen ist, umfaßt der Kühler 3 ein erstes und ein zweites Kühlerteil 8, 9, zwischen denen die Laserdiodeneinheit 2 angeordnet ist. Sowohl das erste Kühlerteil 8 als auch das zweite Kühlerteil 9 weisen als Aufnahmebereich jeweils eine Aufnahmenut 21, 22 auf, wobei beide Kühlerteile 8, 9 hier aus Aluminium oder aus einer Aluminiumlegierung hergestellt sind.

Nachdem die beiden Aufnahmenuten 21, 22 grundsätzlich den gleichen Aufbau aufweisen, wird nachfolgend im Detail lediglich die Aufnahmenut 21 des ersten Kühlerteiles 8 beschrieben.

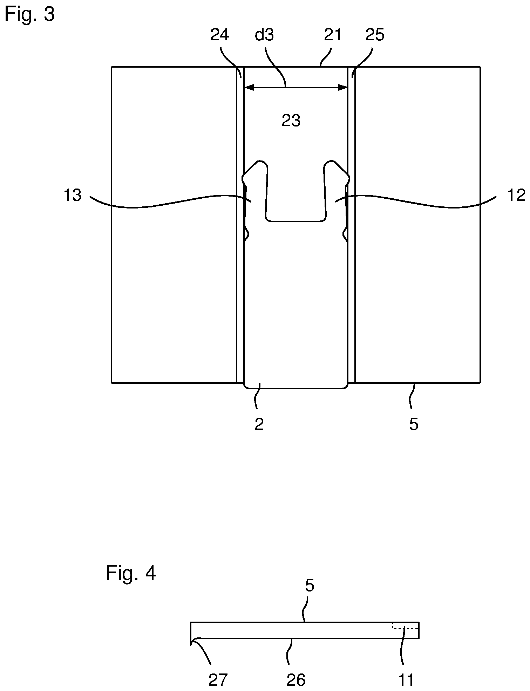

In Fig. 3 ist eine Draufsicht des Lasermoduls 1 von Fig. 1 gezeigt, wobei jedoch das zweite Kühlerteil 9 nicht dargestellt ist, so daß die Aufnahmenut 21 des ersten Kühlerteiles 8 in Draufsicht sichtbar ist. Die Aufnahmenut 21 weist einen ebenen Boden 23 auf, an den sich seitlich zwei nach außen geneigte Seitenwände 24, 25 anschließen. Die Seitenwände 24, 25 sind so geneigt, daß die Breite d3 der Aufnahmenut 21 am Boden 23 am geringsten ist und mit zunehmendem Abstand vom Boden zunimmt. Die Aufnahmenut 21 kann daher auch als V-Nut bezeichnet werden. Die Breite des Bodens d3 ist so gewählt, daß sie der Breite d2 des Ober- und Unterteils 4, 5 entspricht.

Zum Zusammenbau des Lasermoduls 1 wird die Laserdiodeneinheit 2 von oben in die Aufnahmenut 21 des ersten Kühlerteils 8 so eingesetzt wird, bis die Unterseite 26 des Unterteils 5 auf dem Boden 23 aufliegt, wodurch die beiden Schenkel 12, 13 des Unterteiles 5 zueinander hin gedrückt werden, da die seitlich vorstehenden Kontaktnasen 14, 17 des Unterteils 5 durch die Seitenwände 24 und 25 mit einer Kraft zur jeweils anderen Seitenwand 25, 24 beaufschlagt werden. Dies bewirkt jedoch, daß zumindest die kaum vermeidbare Oxidschicht auf den Seitenwänden 24, 25 aufgebrochen und dadurch die Kontaktnasen 14, 17 des Unterteils 5 in die Seitenwände 24, 25 gedrückt werden.

Die Seitenwände 24, 25 können somit als Kontaktflächen des Kühlers 3 und die Seitenflächen der Schenkel 12, 13, an denen die Kontaktnasen 14, 17 ausgebildet sind, können somit als Kontaktflächen der Wärmesenke 6 bezeichnet werden.

Die Schenkel 12, 13 sind daher so ausgelegt, daß sie elastisch verformbar sind (Biegen der Schenkel 12, 13 in Richtung der Pfeile P1 und P2 in Fig. 2), wobei bei dem beschriebenen Einsetzen eine so hohe Rückstellkraft vorhanden ist, um das gewünschte Eindringen der Kontaktnasen 14, 17 des Unterteils in die Seitenwände 24, 25 zu gewährleisten. Es wird somit beim Einsetzen der Laserdiodeneinheit 2 in die Aufnahmenut 21 des ersten Kühlerteils 8 ein mechanisches Aufbrechen der Oxidschicht auf den Seitenwänden 24, 25 bewirkt, wodurch eine ausgezeichnete elektrische Kontaktierung mit einem sehr geringen Übergangswiderstand zwischen dem Unterteil 5 und den Seitenwänden 24, 25 der Aufnahmenut 21 und somit mit dem ersten Kühlerteil 8 erreicht wird. Die Seitenwände 24, 25 bilden somit jeweils eine erste Kontaktfläche. Natürlich liegt auch eine elektrische Kontaktierung über den Boden vor.

Durch die Schenkel 12, 13, die gegen die Seitenwände 24, 25 drücken, wird ferner noch eine Arretierung der Laserdiodeneinheit 2 im ersten Kühlerteil 8 erreicht, so daß auf weitere Mittel (wie z.B. Kleber) zur mechanischen Fixierung verzichtet werden kann.

Auf die so im ersten Kühlerteil 8 angeordnete Laserdiodeneinheit 2 wird das zweite Kühlerteil 9 aufgesetzt, so daß aufgrund der gleich ausgebildeten Aufnahmenut 22 in gleicher Weise nun die Kontaktnasen 14 und 17 des Oberteils 4 in die Seitenwände der Aufnahmenut 22 eindringen und somit die gewünschte elektrische Kontaktierung mit äußerst geringem Übergangswiderstand zwischen dem Oberteil 4 und dem zweiten Kühlerteil 9 erreicht wird. Die Seitenwände der Aufnahmenut 22 bilden somit jeweils eine zweite Kontaktfläche. Natürlich liegt auch eine elektrische Kontaktierung über den Boden vor.

Ferner drücken aufgrund der Rückstellkraft der Schenkel 12, 13 des Oberteils 4 die Kontaktnasen 14, 17 gegen die Seitenwände der Aufnahmenut 22 des zweiten Kühlerteils 9, so daß dadurch eine mechanische Fixierung zwischen der Laserdiodeneinheit 2 und dem zweiten Kühlerteil 9 erreicht wird.

Die Laserdiodeneinheit 2 kann so aufgebaut sein, daß die Schenkel 12, 13 von Ober- und Unterteil 4, 5 durch die elektrisch isolierende Beschichtung nicht im direkten elektrischen Kontakt miteinander stehen und gleichzeitig auch nicht mechanisch fest miteinander verbunden sind. Dies kann z.B. dadurch erreicht werden, daß die elektrische isolierende Beschichtung auf dem Unterteil 5 vorgesehen wird und keine Verklebung im Bereich der Schenkel zwischen Ober- und Unterteil 4, 5 durchgeführt wird. In diesem Fall können sich die Schenkel 12, 13 von Ober- und Unterteil 4, 5 voneinander unabhängig bewegen, was eine äußerst gute elektrische Kontaktierung sowie mechanische Fixierung ermöglicht. Natürlich ist es alternativ auch möglich, daß die Schenkel 12, 13 von Ober- und Unterteil 4, 5 mechanisch miteinander fest verbunden sind. Auch in diesem Fall wird eine gute elektrische Kontaktierung und mechanische Fixierung der Laserdiodeneinheit 2 in den beiden Kühlerteilen 8, 9 erreicht.

Zwischen den beiden Kühlerteilen 8 und 9 ist eine elektrisch isolierende Schicht (nicht gezeigt) vorgesehen, so daß kein direkter elektrischer Kontakt zwischen den beiden Kühlerteilen 8 und 9, der zu einem Kurzschluß führen würde, vorliegt. Bei der elektrisch isolierenden Schicht kann es sich um eine spezielle Beschichtung, um einen Kleber oder auch um einen Luftspalt handeln. Ein Luftspalt wird beispielsweise dadurch erreicht, daß die Tiefe beider Aufnahmenuten 21 und 22 geringer ist als die Dicke der Laserdiodeneinheit 2 in einer Richtung senkrecht zu der Darstellung von Fig. 3. Über die beiden Kühlerteile 8, 9 kann die Laserdiodeneinheit 2 und dadurch die Laserdiode 7 mit Strom beaufschlagt werden, so daß die gewünschte Laserstrahlung erzeugt werden kann.

Durch diese Art der Kontaktierung (Aufbrechen der Oxidschicht und dadurch Eindringen der Kontaktnasen von Ober- und Unterteil in die Seitenwände der Aufnahmenuten 21 und 22) konnte der Übergangswiderstand im Vergleich zu einem Aufbau, bei dem die Oxidschicht nicht aufgebrochen wurde, um eine Größenordnung verringert werden. Es wurden Übergangswiderstände von kleiner als 50 µOhm erreicht, was bei üblichen Stromstärken von bis zu 100 A von großem Vorteil ist.

Die beiden Kühlerteile 8, 9 sind hier zur Vereinfachung der Darstellung als Blöcke dargestellt. Natürlich können die Kühlerteile 8, 9 in jeder dem Fachmann bekannten Art ausgebildet sein.

In Fig. 4 ist eine Seitenansicht des Unterteiles 5 gezeigt. Da das Unterteil 5 sowie das Oberteil 4 bevorzugt durch Stanzen hergestellt ist, sind stets Grate 27 vorhanden, wie dies schematisch dargestellt ist. Solche Grate 27, die auch als Stanznasen 27 bezeichnet werden können, können zusätzlich oder alternativ zu den beschriebenen Kontaktnasen 14, 17 als Kontaktnasen eingesetzt werden. In diesem Fall wird bevorzugt die Oxidschicht auf dem Boden 23 der Aufnahmenut 21 aufgebrochen, so daß die Stanznase 27 in den Boden der Aufnahmenut 21, 22 eindringt. In diesem Fall bildet der Boden eine Kontaktfläche der Aufnahmenut 21, 22 und bildet die Unterseite 26 eine Kontaktfläche der Wärmesenke 6 bzw. des Unterteils 5 der Wärmesenke 6. Die Herstellung dieser Art von Kontaktnasen 27 ist sehr kostengünstig, da die Stanznasen stets bei der Herstellung mittels Stanzen entstehen und der sonst notwendige Schritt der Entgratung weggelassen werden kann.

Die Aufnahmenut 21, 22 muß nicht als V-Nut ausgebildet sein. So kann die Aufnahmenut 21, 22 beispielsweise einen rechteckförmigen Querschnitt (bei dem beide Seitenwände 24, 25 zueinander parallel verlaufen) aufweisen. Diese Form der Aufnahmenut 21, 22 kann beispielsweise insbesondere für die Variante mit den Stanznasen 27 eingesetzt werden. Die rechteckförmige Nut kann jedoch auch bei der Variante mit den Kontaktnasen 14, 17 gemäß Fig. 2 eingesetzt werden, wobei dann bevorzugt die Kontaktnasen eine Fase aufweisen, um das Einsetzen in die Nut 21 , 22 zu erleichtern.

## Patentansprüche

1. Lasermodul mit
einem Kühler (3), der einen ersten Aufnahmebereich (21, 22) mit einer ersten Kontaktfläche (23, 24, 25) aufweist,
einer Laserdiodeneinheit (2), die eine Laserdiode (7) sowie eine zweite Kontaktfläche aufweist, und einer an der ersten oder zweiten Kontaktfläche (23-25) ausgebildeten Kontaktnase (14, 17, 27),
wobei die Laserdiodeneinheit (2) im ersten Aufnahmebereich (21, 22) positioniert ist und die Kontaktnase (14; 17; 27) aufgrund des Positionierens der Laserdiodeneinheit (2) in die erste oder zweite Kontaktfläche (23, 24, 25) gedrückt ist, um den elektrischen Übergangswiderstand zwischen der Laserdiodeneinheit (2) und dem Kühler (3) zu verringern, wobei die Kontaktnase eine Passivierung der Kontaktfläche, in die sie beim Positionieren der Laserdiodeneinheit gedrückt wird, aufbricht oder durchstößt, wobei die Laserdiodeneinheit (2) eine Wärmesenke (6) aufweist und die Laserdiode (7) an der Wärmesenke (6) befestigt ist und die Kontaktnase (14, 1 7, 27) an der Wärmesenke (6) ausgebildet ist und die Wärmesenke (6) ein Ober- und Unterteil (4, 5) aufweist, zwischen denen die Laserdiode (7) angeordnet ist, wobei sowohl das Oberteil (4) als auch das Unterteil (5) jeweils zumindest eine vorstehende Kontaktnase (14, 17) umfasst,
wobei der Kühler (3) ein erstes Kühlerteil (8) mit dem ersten Aufnahmebereich (21) sowie ein zweites Kühlerteil (9) mit einem zweiten Aufnahmebereich (22), der eine dritte Kontaktfläche aufweist, umfasst, wobei das Unterteil (5) im ersten Aufnahmebereich (21) positioniert ist und das Oberteil (4) im zweiten Aufnahmebereich (22) des zweiten Kühlerteils (9) so positioniert ist, dass die zumindest eine vorstehende Kontaktnase des Oberteils (4) aufgrund des Positionierens in die dritte Kontaktfläche des zweiten Kühlerteils (9) gedrückt ist, um den elektrischen Übergangswiderstand zwischen der Laserdiodeneinheit (2) und dem Kühler (3) zu verringern, wobei die Kontaktnase die Passivierung der Kontaktfläche, in die sie beim Positionieren der Laserdiodeneinheit gedrückt wird, aufbricht oder durchstößt, wobei die Passivierung eine elektrisch isolierende Schicht oder Beschichtung ist.

2. Lasermodul nach Anspruch 1, bei dem die vorstehende Kontaktnase (27) als Grat (27) ausgebildet ist.

3. Lasermodul nach Anspruch 1 oder 2, bei dem der erste Aufnahmebereich als erste Aufnahmenut (21, 22) mit einem Boden (23) und zwei Seitenwänden (24, 25) ausgebildet ist, wobei der Boden (23) oder eine der beiden Seitenwände (24, 25) die erste Kontaktfläche bildet und/oder der zweite Aufnahmebereich (22) des zweiten Kühlerteils (9) als Aufnahmenut (22) mit einem Boden und zwei Seitenwänden ausgebildet ist, wobei der Boden oder eine der beiden Seitenwänden der zweiten Aufnahmenut (22) die dritte Kontaktfläche bildet.

4. Lasermodul nach einem der obigen Ansprüche, bei dem die Kontaktnase an einem elastischen Schenkel (12, 13) der Wärmesenke (6) ausgebildet ist.

5. Lasermodul nach Anspruch 3 oder 4,, bei dem die Breite (d1) der Wärmesenke (6) im Bereich der Kontaktnase (14, 17) größer ist als die minimale Breite (d3) der ersten Aufnahmenut (21 , 22).

6. Lasermodul nach Anspruch 1 bis 5, bei dem vom Ober- und Unterteil (4, 5) zumindest eines einen Hauptabschnitt (10) mit einer Vertiefung (11) am vorderen Ende zur Aufnahme der Laserdiode (7) sowie zumindest einen elastischen Schenkel (12, 13) mit einer Kontaktnase (14, 17) am hinteren Ende des Hauptabschnittes (10) aufweist.

7. Lasermodul nach einem der Ansprüche 1 bis 6, bei dem die elektrische Kontaktierung der Laserdiode (7) einerseits über das erste Kühlerteil (8) und das Unterteil (5) und andererseits über das zweite Kühlerteil (9) und das Oberteil (4) bewirkt ist.

8. Lasermodul nach einem der Ansprüche 1 bis 7, bei dem die Wärmesenke (6) aus Kupfer oder einer Kupferlegierung hergestellt ist und/oder der Kühler (3) aus Aluminium oder einer Aluminiumlegierung hergestellt ist.

9. Verfahren zum Herstellen eines Lasermoduls mit
einem Kühler, der einen ersten Aufnahmebereich mit einer ersten Kontaktfläche aufweist, und einer Laserdiodeneinheit, die eine Laserdiode sowie eine zweite Kontaktfläche aufweist, wobei an einer der ersten oder zweiten Kontaktfläche eine Kontaktnase ausgebildet wird und die Laserdiodeneinheit im ersten Aufnahmebereich positioniert und dabei die Kontaktnase in die andere der ersten oder zweiten Kontaktfläche gedrückt wird, um den elektrischen Übergangswiderstand zwischen der Laserdiodeneinheit und dem Kühler zu verringern, wobei die Kontaktnase eine Passivierung der Kontaktfläche, in die sie beim Positionieren der Laserdiodeneinheit gedrückt wird, aufbricht oder durchstößt,
wobei die Laserdiodeneinheit eine Wärmesenke aufweist und die Laserdiode an der Wärmesenke befestigt wird und die Kontaktnase an der Wärmesenke ausgebildet wird
und die Wärmesenke ein Ober- und Unterteil aufweist, zwischen denen die Laserdiode angeordnet wird, wobei sowohl das Oberteil als auch das Unterteil jeweils zumindest mit einer vorstehenden Kontaktnase ausgebildet werden,
wobei der Kühler ein erstes Kühlerteil mit dem ersten Aufnahmebereich sowie ein zweites Kühlerteil mit einem zweiten Aufnahmebereich, der eine dritte Kontaktfläche aufweist, umfasst, wobei das Unterteil im ersten Aufnahmebereich positioniert wird und das Oberteil so im zweiten Aufnahmebereich des zweiten Kühlerteils positioniert wird, dass dabei die zumindest eine vorstehende Kontaktnase des Oberteils in die dritte Kontaktfläche des zweiten Kühlerteils gedrückt wird, um den elektrischen Übergangswiderstand zwischen der Laserdiodeneinheit und dem Kühler zu verringern, wobei die Kontaktnase die Passivierung der Kontaktfläche, in die sie beim Positionieren der Laserdiodeneinheit gedrückt wird, aufbricht oder durchstößt, wobei die Passivierung eine elektrisch isolierende Schicht oder Beschichtung ist.

10. Verfahren nach Anspruch 9, bei dem die vorstehende Kontaktnase als Grat ausgebildet wird.

11. Verfahren nach Anspruch 9 oder 10 , bei dem der erste Aufnahmebereich als erste Aufnahmenut mit einem Boden und zwei Seitenwänden ausgebildet wird, wobei der Boden oder eine der beiden Seitenwände die erste Kontaktfläche bildet und/oder der zweite Aufnahmebereich des zweiten Kühlerteils als Aufnahmenut mit einem Boden und zwei Seitenwänden ausgebildet wird, wobei der Boden oder eine der beiden Seitenwänden der zweiten Aufnahmenut die dritte Kontaktfläche bildet.

12. Verfahren nach einem der Ansprüche 9 bis 11, bei dem die Kontaktnase während des Positionierens im ersten Aufnahmebereich an der ersten Kontaktfläche entlang kratzt und dabei eine auf der Kontaktnase und/oder der ersten Kontaktfläche vorhandene Passivierung aufbricht.

13. Verfahren nach Anspruch 9, bei dem die Kontaktnase an einem elastischen Schenkel der Wärmesenke ausgebildet wird.

14. Verfahren nach Anspruch 9 , bei dem vom Ober- und Unterteil zumindest eines so ausgebildet wird, dass es einen Hauptabschnitt mit einer Vertiefung am vorderen Ende zur Aufnahme der Laserdiode sowie zumindest einen elastischen Schenkel mit einer Kontaktnase am hinteren Ende des Hauptabschnittes aufweist.

15. Verfahren nach einem der Ansprüche 9 bis 14, bei dem die elektrische Kontaktierung der Laserdiode einerseits über das erste Kühlerteil und das Unterteil und andererseits über das zweite Kühlerteil und das Oberteil bewirkt wird.

## Claims

1. Laser module comprising
a cooler (3), which has a first receptacle region (21, 22) with a first contact pad (23, 24, 25),
a laser diode unit (2), which has a laser diode (7) and also a second contact pad, and
a contact lug (14, 17, 27) formed at the first or second contact pad (23-25),
wherein the laser diode unit (2) is positioned in the first receptacle region (21, 22) and, on account of the positioning of the laser diode unit (2), the contact lug (14; 17; 27) is pressed into the first or second contact pad (23, 24, 25) in order to reduce the electrical contact resistance between the laser diode unit (2) and the cooler (3), wherein the contact lug breaks up or penetrates through a passivation of the contact pad into which it is pressed during the positioning of the laser diode unit,
wherein the laser diode unit (2) has a heat sink (6) and the laser diode (7) is secured to the heat sink (6) and the contact lug (14, 17, 27) is formed at the heat sink (6) and the heat sink (6) has an upper and lower part (4, 5), between which the laser diode (7) is arranged, wherein both the upper part (4) and the lower part (5) in each case comprise at least one projecting contact lug (14, 17),
wherein the cooler (3) comprises a first cooler part (8) with the first receptacle region (21) and also a second cooler part (9) with a second receptacle region (22), which has a third contact pad, wherein the lower part (5) is positioned in the first receptacle region (21) and the upper part (4) is positioned in the second receptacle region (22) of the second cooler part (9) such that, on account of the positioning, the at least one projecting contact lug of the upper part (4) is pressed into the third contact pad of the second cooler part (9) in order to reduce the electrical contact resistance between the laser diode unit (2) and the cooler (3), wherein the contact lug breaks up or penetrates through the passivation of the contact pad into which it is pressed during the positioning of the laser diode unit, wherein the passivation is an electrically insulating layer or coating.

2. Laser module according to Claim 1, wherein the projecting contact lug (27) is configured as a burr (27) .

3. Laser module according to Claim 1 or 2, wherein the first receptacle region is configured as a first receptacle groove (21, 22) having a base (23) and two sidewalls (24, 25), wherein the base (23) or one of the two sidewalls (24, 25) forms the first contact pad, and/or the second receptacle region (22) of the second cooler part (9) is configured as a receptacle groove (22) having a base and two sidewalls, wherein the base or one of the two sidewalls of the second receptacle groove (22) forms the third contact pad.

4. Laser module according any of the preceding claims, wherein the contact lug is formed at an elastic limb (12, 13) of the heat sink (6).

5. Laser module according to Claim 3 or 4, wherein the width (d1) of the heat sink (6) in the region of the contact lug (14, 17) is greater than the minimum width (d3) of the first receptacle groove (21, 22).

6. Laser module according to Claim 1 to 5, wherein at least one of the upper and lower part (4, 5) has a main section (10) with a depression (11) at the front end for receiving the laser diode (7) and also at least one elastic limb (12, 13) with a contact lug (14, 17) at the rear end of the main section (10) .

7. Laser module according to any of Claims 1 to 6, wherein the electrical contacting of the laser diode (7) is effected firstly via the first cooler part (8) and the lower part (5) and secondly via the second cooler part (9) and the upper part (4).

8. Laser module according to any of Claims 1 to 7, wherein the heat sink (6) is produced from copper or a copper alloy and/or the cooler (3) is produced from aluminium or an aluminium alloy.

9. Method for producing a laser module comprising a cooler, which has a first receptacle region with a first contact pad, and a laser diode unit, which has a laser diode and also a second contact pad, wherein a contact lug is formed at one of the first or second contact pad and the laser diode unit is positioned in the first receptacle region and in the process the contact lug is pressed into the other of the first or second contact pad in order to reduce the electrical contact resistance between the laser diode unit and the cooler, wherein the contact lug breaks up or penetrates through a passivation of the contact pad into which it is pressed during the positioning of the laser diode unit,
wherein the laser diode unit has a heat sink and the laser diode is secured to the heat sink and the contact lug is formed at the heat sink and the heat sink has an upper and lower part, between which the laser diode is arranged, wherein both the upper part and the lower part are formed in each case with at least one projecting contact lug,
wherein the cooler comprises a first cooler part with the first receptacle region and also a second cooler part with a second receptacle region, which has a third contact pad, wherein the lower part is positioned in the first receptacle region and the upper part is positioned in the second receptacle region of the second cooler part such that in the process the at least one projecting contact lug of the upper part is pressed into the third contact pad of the second cooler part in order to reduce the electrical contact resistance between the laser diode unit and the cooler, wherein the contact lug breaks up or penetrates through the passivation of the contact pad into which it is pressed during the positioning of the laser diode unit, wherein the passivation is an electrically insulating layer or coating.

10. Method according to Claim 9, wherein the projecting contact lug is configured as a burr.

11. Method according to Claim 9 or 10, wherein the first receptacle region is configured as a first receptacle groove having a base and two sidewalls, wherein the base or one of the two sidewalls forms the first contact pad, and/or the second receptacle region of the second cooler part is configured as a receptacle groove having a base and two sidewalls, wherein the base or one of the two sidewalls of the second receptacle groove forms the third contact pad.

12. Method according to any of Claims 9 to 11, wherein during the positioning in the first receptacle region the contact lug scratches along the first contact pad and in the process breaks up a passivation present on the contact lug and/or the first contact pad.

13. Method according to Claim 9, wherein the contact lug is formed at an elastic limb of the heat sink.

14. Method according to Claim 9, wherein at least one of the upper and lower part is configured such that it has a main section with a depression at the front end for receiving the laser diode and also at least one elastic limb with a contact lug at the rear end of the main section.

15. Method according to any of Claims 9 to 14, wherein the electrical contacting of the laser diode is effected firstly via the first cooler part and the lower part and secondly via the second cooler part and the upper part.

## Revendications

1. Module laser comportant un refroidisseur (3), qui présente une première zone de réceptacle (21, 22) avec une première surface de contact (23, 24, 25), une unité de diode laser (2), qui présente une diode laser (7) ainsi qu'une deuxième surface de contact et un nez de contact (14, 17, 27) réalisé sur la première ou la deuxième surface de contact (23-25), dans lequel l'unité de diode laser (2) est positionnée dans la première zone de réceptacle (21, 22) et le nez de contact (14, 17, 27) est pressé en raison du positionnement de l'unité de diode laser (2) dans la première ou la deuxième surface de contact (23, 24, 25), afin de diminuer la résistance de contact électrique entre l'unité de diode de contact (2) et le refroidisseur (3), dans lequel le nez de contact interrompt ou autorise une passivation de la surface de contact, dans laquelle il est pressé lors du positionnement de l'unité de diode laser, dans lequel l'unité de diode laser (2) présente un dissipateur thermique (6) et la diode laser (7) est fixée sur le dissipateur thermique (6) et le nez de contact (14, 17, 27) est réalisé sur le dissipateur thermique (6) et le dissipateur thermique (6) présente une partie supérieure et une partie inférieure (4, 5), entre lesquelles la diode laser (7) est disposée, dans lequel tant la partie supérieure (4) que la partie inférieure (5) comprend respectivement au moins un nez de contact dépassant en saillie (14, 17),
dans lequel le refroidisseur (3) comprend une première partie de refroidisseur (8) avec la première zone de réceptacle (21) ainsi qu'une deuxième partie de refroidisseur (9) avec une deuxième zone de réceptacle (22), qui présente une troisième surface de contact, dans lequel la partie inférieure (5) est positionnée dans la première zone de réceptacle (21) et la partie supérieure (4) est positionnée dans la deuxième zone de réceptacle (22) de la deuxième partie de refroidisseur (9), de sorte que au moins un nez de contact dépassant en saillie de la partie supérieure (4) soit pressé en raison du positionnement dans la troisième surface de contact de la deuxième partie de refroidisseur (9), afin de diminuer la résistance de contact électrique entre l'unité de diode laser (2) et le refroidisseur (3), dans lequel le nez de contact interrompt ou autorise la passivation de la surface de contact, dans laquelle il est pressé lors du positionnement de l'unité de diode laser, dans lequel la passivation est une couche ou un revêtement électriquement isolant.

2. Module laser selon la revendication 1, dans lequel le nez de contact dépassant en saillie (27) est configuré comme une arête (27).

3. Module laser selon la revendication 1 ou 2, dans lequel la première zone de réceptacle est conçue comme une première rainure de réceptacle (21, 22) avec un fond (23) et deux parois latérales (24, 25), dans lequel le fond (23) ou une des deux parois latérales (24, 25) forme la première surface de contact et/ou la deuxième zone de réceptacle (22) de la deuxième partie de refroidisseur (9) est conçue comme une rainure de réceptacle (22) avec un fond et deux parois latérale, dans lequel le fond ou une des deux parois latérales de la deuxième rainure de réceptacle (22) forme la troisième surface de contact.

4. Module laser selon une des revendications dessus, dans lequel le nez de contact est réalisé sur un pan élastique (12 ,13) du dissipateur thermique (6) .

5. Module laser selon la revendication 3 ou 4, dans lequel la largeur (d1) du dissipateur thermique (6) au niveau du nez de contact (14, 17) est plus grande que la largeur minimale (d3) de la première rainure de réceptacle (21, 22).

6. Module laser selon la revendication 1 à 5, dans lequel de la partie supérieure et la partie inférieure (4, 5) au moins une présente une portion principale (10) avec une cavité (11) à l'extrémité avant pour recevoir la diode laser (7) ainsi qu'au moins un pan élastique (12, 13) avec un nez de contact (14, 17) à l'extrémité arrière de la portion principale (10).

7. Module laser selon une des revendications 1 à 6, dans lequel le contact électrique de la diode laser (7) est effectué d'un côté par l'intermédiaire de la première partie de refroidisseur (8) et la partie inférieure (5) et d'un autre côté par l'intermédiaire de la deuxième partie de refroidisseur (9) et la partie supérieure (4).

8. Module laser selon une des revendications 1 à 7, dans lequel le dissipateur thermique (6) est fabriqué en cuivre ou dans un alliage de cuivre et/ou le refroidisseur (3) est fabriqué en aluminium ou dans un alliage d'aluminium.

9. Procédé de fabrication d'un module laser comportant
un refroidisseur, qui présente une première zone de réceptacle avec une première surface de contact, et une unité de diode laser, qui présente une diode laser ainsi qu'une deuxième surface de contact, dans lequel un nez de contact est réalisé sur une de la première ou la deuxième surface de contact et l'unité de diode laser est positionnée dans une première zone de réceptacle et ainsi le nez de contact est pressé dans l'autre de la première ou la deuxième surface de contact, afin de diminuer la résistance de contact électrique entre l'unité de diode laser et le refroidisseur, dans lequel le nez de contact interrompt ou autorise une passivation de la surface de contact, dans laquelle il est pressé lors du positionnement de l'unité de diode laser, dans lequel l'unité de diode laser présente un dissipateur thermique et la diode laser est fixée sur le dissipateur thermique et le nez de contact est réalisée sur le dissipateur thermique et le dissipateur thermique présente une partie supérieure et une partie inférieure, entre lesquelles la diode laser est disposée, dans lequel tant la partie supérieure que la partie inférieure sont réalisées respectivement avec au moins un nez de contact dépassant en saillie, dans lequel le refroidisseur comprend une première partie de refroidisseur avec la première zone de réceptacle ainsi qu'une deuxième partie de refroidisseur avec une deuxième zone de réceptacle, qui présente une troisième surface de contact, dans lequel la partie inférieure est positionnée dans une zone de réceptacle et la partie supérieure est positionnée dans la deuxième zone de réceptacle de la deuxième partie de refroidisseur de sorte que ainsi au moins un nez de contact dépassant en saillie de la partie supérieure soit pressé dans la troisième surface de contact de la deuxième partie de refroidisseur, afin de diminuer la résistance de contact électrique entre l'unité de diode laser et le refroidisseur, dans lequel le nez de contact interrompt ou autorise la passivation de la surface de contact, dans laquelle il est pressé lors du positionnement de l'unité de diode laser, dans lequel la passivation est une couche ou un revêtement électriquement isolant.

10. Procédé selon la revendication 9, dans lequel le nez de contact dépassant en saillie est configuré comme une arête.

11. Procédé selon la revendication 9 ou 10, dans lequel la première zone de réceptacle est conçue comme une première rainure de réceptacle avec un fond et deux parois latérales, dans lequel le fond ou une des deux parois latérales forme la première surface de contact et/ou la deuxième zone de réceptacle de la deuxième partie de refroidisseur est conçue comme une rainure de réceptacle avec un fond et deux parois latérales, dans lequel le fond ou une des deux parois latérales de la deuxième rainure de réceptacle forme la troisième surface de contact.

12. Procédé selon une des revendications 9 à 11, dans lequel le nez de contact pendant le positionnement dans la première zone de réceptacle griffe le long de la première surface de contact et interrompt ainsi une passivation existante sur le nez de contact et/ou la première surface de contact.

13. Procédé selon la revendication 9, dans lequel le nez de contact est conçu sur un pan élastique du dissipateur thermique.

14. Procédé selon la revendication 9, dans lequel, parmi la partie supérieure et la partie inférieure, au moins l'une est réalisée de telle sorte qu'elle présente une portion principale avec un renfoncement au niveau de l'extrémité avant pour recevoir la diode laser ainsi qu'au moins une branche élastique avec un nez de contact à l'extrémité arrière de la portion principale.

15. Procédé selon l'une quelconque des revendications 9 à 14, dans lequel le contact électrique de la diode laser est réalisé d'une part par le biais de la première partie de refroidisseur et de la partie inférieure et d'autre part par le biais de la deuxième partie de refroidisseur et de la partie supérieure.
